Europäisches Patentamt

European Patent Office

Office européen des brevets

(11) Numéro de publication: **0 313 460**
**A1**

## DEMANDE DE BREVET EUROPEEN

(21) Numéro de dépôt: **88402636.0**

(22) Date de dépôt: **19.10.88**

(51) Int. Cl.⁴: **H 03 M 1/60**
**H 03 M 1/52**

(30) Priorité: **21.10.87 FR 8714535**

(43) Date de publication de la demande:
**26.04.89 Bulletin 89/17**

(84) Etats contractants désignés:
**CH DE GB IT LI NL**

(71) Demandeur: **COMMISSARIAT A L'ENERGIE ATOMIQUE**
**31/33, rue de la Fédération**
**F-75015 Paris (FR)**

(72) Inventeur: **Poujois, Robert**
**Les Jaillets - Sinard**
**F-38650 Monestier-de-Clermont (FR)**

(74) Mandataire: **Mongrédien, André et al**
**c/o BREVATOME 25, rue de Ponthieu**
**F-75008 Paris (FR)**

(54) **Convertisseur analogique numérique à grande dynamique.**

(57) Un convertisseur analogique numérique comporte des moyens (15, 16) de quantification gros et des moyens (24, 19) de quantification fins. Les moyens de quantification gros sont du type conversion courant-fréquence ou tension-fréquence à fréquence variable. Les moyens de quantification fins comportent des moyens pour mesurer la durée de décharge d'une charge résiduelle stockée dans un condensateur (3) d'intégration à l'issue de la phase de quantification grosse. Les moyens de décharge de ce condensateur comprennent un condensateur (14) de quantification de cette décharge.

FIG_1

EP 0 313 460 A1

**Description**

## CONVERTISSEUR ANALOGIQUE NUMERIQUE A GRANDE DYNAMIQUE

La présente invention a pour object un convertisseur analogique numérique à grande dynamique. Ce convertisseur peut être utilisé dans toutes les applications de conversion. Il peut en particulier être utilisé dans des tomodensitomètres afin d'obtenir une mesure numérique du courant sortant des chambres d'ionisation d'un détecteur à rayons X. Ce convertisseur peut néanmoins trouver son utilisation dans d'autres domaines, notamment lorsque les signaux à convertir sont des signaux électriques de courant faible, lorsqu'il est nécéssaire de mesurer simultanément plusieurs signaux en parallèle, ou encore lorsque l'intégration en technologie M O S de ce convertisseur s'avère nécéssaire.

Les convertisseurs sont, dans l'état de la technique, de types suivants. Ils sont des convertisseurs dits à équilibrage de charge, précis et pour certains assez rapides, ou des convertisseurs dits flash, très rapides mais peu précis. Les convertisseurs à équilibrage de charge peuvent être des convertisseurs double rampe, précis, et donnant un résultat de mesure sur n points au bout d'une durée 2n fois le temps de cycle d'une horloge de comptage contenu dans ces convertisseurs. Ils peuvent être des convertisseurs tension - fréquence ou courant -fréquence, eux aussi précis et deux fois plus rapides que les convertisseurs double rampe. Ils peuvent être aussi des convertisseurs à modulation delta. Tous les convertisseurs peuvent être précédés d'un échantillonneur-bloqueur pour mémoriser la valeur du signal sur un temps très court et le convertir ensuite. En outre, on peut ajouter à l'entrée de tous les convertisseurs un signal de polarisation Vo pour limiter la dynamique de Vo à Vo plus le signal à convertir.

Les convertisseurs à équilibrage de charge comportent tous un asservissement ou des seuils servant à équilibrer les charges. Dans tous ces convertisseurs le signal est soit un courant, soit une tension transformée en courant par une résistance. On mesure la charge totale apportée par ce courant pendant un temps donné To. Le principe est toujours le même. La charge vient s'accumuler dans un condensateur d'un intégrateur et on retire de ce condensateur des charges de valeurs connues soit identiques, soit différentes, soit continuement, soit par paquet de charges, soit pendant le temps To, soit après ce temps To, soit pendant et après ce temps To. Celà revient de toutes façons à retirer des charges de valeurs connues pour avoir au bout d'un certain temps une charge nulle dans le condensateur d'accumulation. Ainsi la charge totale apportée par le signal à convertir a été transformée en un nombre de charges connu. Ce nombre représente une mesure numérique du signal.

Dans un convertisseur double rampe on accumule pendant une durée To dans le condensateur et on retire des charges continuement après To. Le temps de décharge est représentatif de la mesure du signal. Dans un convertisseur tension -fréquence ou courant - fréquence, des charges constantes discrètes sont retirées pendant To de telle façon que la tension aux bornes du condensateur reste faible. La fréquence d'extraction des charges est représentative de la mesure du signal. Dans les convertisseurs à modulation delta, des charges discrètes de valeur connues identiques positives ou négatives sont injectées à fréquence fixe. Le signe de chaque charge est choisi de telle façon que la tension aux bornes du condensateur reste faible. Ces charges sont injectées pendant le temps d'accumulation To. La différence entre le nombre des charges positives et le nombre des charges négatives est représentative de la mesure du signal.

Ci après est décrit de façon plus précise le principe particulier du convertisseur tension -fréquence ou courant - fréquence. Celui-ci consiste à utiliser un intégrateur analogique recevant en entrée la somme du signal à numériser, autrement dit à quantifier et d'un certain nombre de charges de quantification de valeurs identiques, la polarité desdites charges étant inverse à celle du signal à quantifier. Le débit moyen des charges de quantification est proportionnel, à une charge résiduelle près, à l'amplitude du signal à quantifier, la fréquence d'injection de ces charges étant variable et fonction de cette amplitude.

Le comptage du nombre des charges électriques quantifiées injectées à l'entrée de l'intégrateur est organisé de la manière suivante. La sortie de l'intégrateur est connectée à l'entrée d'un comparateur à seuil de tension. La sortie du comparateur à seuil est reliée à un générateur de charges quantifiées. Lorsque le signal à quantifier est introduit dans l'intégrateur, l'intégrateur commence à intégrer ce signal : le signal de sortie de cet intégrateur évolue avec le temps. Lorsque la sortie de l'intégrateur atteint le seuil du comparateur à seuil, ce comparateur bascule, et une charge quantifiée est injectée à l'entrée de l'intégrateur, de manière à faire varier en sens inverse brutalement le signal de sortie de cet intégrateur. Cependant le signal à quantifier continue à être introduit à l'entrée de l'intégrateur de telle sorte que le signal de sortie de l'intégrateur recommence à évoluer et de telle sorte que ce cycle se reproduit. Il est important de remarquer que ce cycle se reproduit à un rythme d'autant plus rapide que le signal à quantifier est lui-même élevé. Le principe de la quantification est alors simple : pendant une durée donnée on compte le nombre de fois qu'il a été nécéssaire d'injecter des charges électriques quantifiées dans l'intégrateur. Ainsi par exemple, pour une durée de comptage de l'ordre d'une milliseconde, en utilisant une chaîne d'intégration-injection susceptible d'admettre un rythme de 10 MHz on peut compter, pour un signal d'amplitude maximum, jusqu'à dix mille charges injectées. Ceci correspond à un convertisseur de dix mille points de mesure. En mode binaire ceci est sensiblement équivalent à 14 bits dits de poids fort.

Cependant, dans certaines applications et en particulier dans l'application de tomodensitométrie envisagée, cette dynamique de quantification est insuffisante. En effet, il est nécéssaire de donner une quantification avec plus de précision par exemple avec de un à cent millions de points de mesure. De façon connue, pour augmenter la précision de la mesure, on utilise alors le fait qu'à l'issue d'une durée donnée affectée à l'élaboration d'une valeur numérique du signal à quantifier, à partir du nombre de charges injectées dans l'intégrateur, celui-ci conserve une charge résiduelle non nulle. Cette charge est due à l'intégration du signal pendant la durée d'intégration qui a succédé à la dernière injection et qui s'est étendue jusqu'à la fin de la durée donnée qui correspond à la fin de l'intégration. En définitive, la quantification de cette charge permet d'augmenter la dynamique du convertisseur. Dans la suite du texte on appellera valeurs de poids fort, les valeurs de numérisation obtenues à partir du nombre de charges injectées dans l'intégrateur, et valeurs de poids faible les valeurs de la numérisation obtenues à partir de la charge résiduelle.

Le principe de la quantification des valeurs de poids faible est alors le suivant : on décharge l'intégrateur en connectant son entrée à un générateur de courant de référence. On mesure la durée au bout de laquelle la sortie de cet intégrateur passe par zéro. Cette durée est représentative des valeurs de poids faible du signal. Pour connaître ces valeurs il suffit de faire fonctionner, au rythme d'une horloge à pas constant, un compteur pendant la durée qui s'étend depuis le début de la décharge jusqu'à l'instant où la sortie de l'intégrateur passe par zéro. Ainsi l'élaboration des valeurs de poids fort est faite par une décharge réitérée de l'intégrateur, alors que l'élaboration des valeurs de poids faible est faite par une mesure du temps de décharge à courant constant des charges résiduelles contenues dans cet intégrateur à l'issue de l'élaboration des valeurs de poids fort. Un convertisseur tenant compte de la charge résiduelle pour numériser un signal est décrit dans un article intitulé "RESOLVE 22 BITS EASILY WITH CHARGE BALANCE ADCs", dû à Monsieur Thomas J. MEGO et publié dans la revue ELECTRONIC DESIGN du 25 juin 1987. Ce convertisseur effectue une conversion de type à équilibre de charge pour déterminer les valeurs de poids fort de la numérisation. Dans ce convertisseur, pour l'élaboration des valeurs de poids fort, un courant Io est injecté à l'entrée du convertisseur pour limiter la dynamique à $(Ix + Io)/Io$, Ix représentant le signal d'entrée du convertisseur, à numériser. Ainsi, la dynamique est suffisamment réduite pour utiliser deux valeurs de charge étalon $Q/8$ et $5\,Q/8$. Ces charges sont élaborées à partir d'une résistance étalon R connectée entre l'entrée de l'intégrateur et d'une source de potentiel de référence Vréf de décharge par l'intermédiaire d'un interrupteur commandé par des impulsions de tension de durées variables. La charge $Q/8$ est injectée en permanence et à fréquence constante. Elle sert à compenser le courant Io. Dès que la charge stockée devient trop grande les charges $Q/8$ sont remplacées par des charges $5\,Q/8$. Cet artifice permet d'injecter à fréquence fixe une charge $Q/8$ ou $5\,Q/8$ selon les besoins d'équilibre de charge. La mesure du nombre des charges injectées donne une mesure en poids fort du signal. Par ailleurs, pour l'élaboration des valeurs de poids faibles, on décharge la charge résiduelle à travers une autre résistance étalon connectée par l'intermédiaire d'un interrupteur à la source de potentiel de référence, les valeurs de poids faibles étant alors déterminées à partir du temps de décharge.

Ce type de convertisseur comporte un certain nombre d'inconvénients. Dans le cas de l'élaboration des valeurs de poids fort, l'interrupteur étant commandé par un oscillateur de décharge à fréquence fixe, a chaque impulsion de tension, l'interrupteur est fermé temporairement et le condensateur de l'intégrateur se décharge de $Q = Vréf\,.\,T/R$. La variation de tension de sortie Vs de l'intégrateur correspondant à cette décharge est fonction de la constante de temps que le condensateur forme avec la résistance étalon, de l'amplitude Vréf du potentiel de référence de décharge et de la durée T pendant laquelle à chaque impulsion l'interrupteur est fermé. $(\Delta Vs = Vréf\,.\,T/R.C)$.

Or, la maîtrise de la durée de fermeture de l'interrupteur est délicate. En effet, si on estime à une milliseconde la durée maximum de conversion, et qu'on veuille dix mille points de précision sur la mesure, il est donc nécéssaire de disposer d'un rythme impulsionnel de l'ordre de 10 MHz. On peut alors facilement montrer que la durée de décharge, étant donné qu'elle est répétée dix mille fois, doit être ajustée plus précisément que le dix millième de sa durée élémentaire. Ceci revient à stabiliser la durée de conduction de l'interrupteur avec cette même précision. La fluctuation de la durée de conduction doit être inférieure au dixième de nanosecond. Ceci est difficile à obtenir. Dans le cas de l'élaboration des valeurs de poids faible, la charge résiduelle résidant dans le condensateur de l'intégrateur à l'issue de la quantification des valeurs de poids fort, est faible. Pour pouvoir la mesurer avec suffisamment de précision, c'est à dire en définitive pendant suffisamment longtemps, il est nécessaire de la décharger avec un courant faible. Pour celà, le condensateur est déchargé par la résistance étalon correspondante.

Compte tenu des charges accumulables dans le condensateur d'intégration, et de la taille envisageable pratiquement pour celui-ci, on est conduit à choisir des résistances étalon de décharge de l'ordre de cent GIGOHMS. Ces résistances sont très chères, et ne peuvent en aucun cas être intégrées dans le cas où le convertisseur est intégré dans un circuit intégré de type MOS. Enfin, le principe de ce convertisseur nécessite donc de maîtriser avec précision plusieurs références : la durée de conduction des interrupteurs, la valeur des résistances étalons, et la stabilité du potentiel de référence.

L'invention a pour objet de remédier à ces inconvénients en proposant un convertisseur utilisant une conversion de type tension -fréquence ou courant-fréquence pour obtenir les valeurs de poids fort de la numérisation et tenant compte de la charge résiduelle afin d'élaborer les valeurs de poids faible de cette numérisation mais dans lequel les références à maîtriser sont moins nombreuses. En particulier il n'est pas nécéssaire d'y définir des résistances étalons de décharge, et la durée de conduction des interrupteurs de décharge n'est plus critique. En pratique, dans l'invention, on utilise une décharge (ou une charge) du condensateur d'intégration de l'intégrateur au travers d'un autre condensateur, dit de quantification, relié à un potentiel de référence Vréf par l'intermédiaire de commutateurs, ce potentiel Vréf étant fixe pour l'élaboration des valeurs de poids forts et fixe ou variable pour l'élaboration des valeurs de poids faibles.

L'invention a donc pour objet un convertisseur analogique numérique à grande dynamique du type comportant

- des moyens pour intégrer un signal à quantifier pendant une durée donnée, ces moyens pour intégrer comportant des moyens pour accumuler des charges provenant du signal à quantifier,
- des moyens pour injecter dans les moyens d'accumulation des charges électriques quantifiées en un nombre proportionnel au dit signal à quantifier, les charges injectées étant de polarité inverse aux charges provenant du signal à quantifier,
- des moyens de comptage dits gros pour compter le nombre des charges quantifiées injectées et en déduire une quantification en valeurs de poids fort du signal,
- des moyens pour prendre en compte et décharger une charge électrique résiduelle accumulée dans les moyens d'accumulation,
- des moyens de comptage dits fins pour compter une durée correspondant à la décharge de la charge résiduelle accumulée et en déduire une quantification en valeurs de poids faible du signal,
- les moyens pour injecter comportant un premier générateur de charges quantifiées muni d'un premier condensateur de quantification de charge, caractérisé en ce que
- les moyens pour prendre en compte et décharger comportent un deuxième générateur de charges muni d'un deuxième condensateur de quantification.

De façon avantageuse le deuxième condensateur de quantification est le même que le premier condensateur de quantification.

L'invention sera mieux comprise à la lecture de la description qui suit et à l'examen des figures qui l'accompagnent. Celles-ci ne sont données qu'à titre indicatif et nullement limitatif de l'invention. Les figures montrent :

- figure 1 : un schéma d'un convertisseur conforme à l'invention '
- figures 2a à 2g : des exemples de diagrammes temporels de signaux électriques utilisés dans le convertisseur de l'invention;
- figure 3 : une variante de réalisation de l'invention plus particulièrement utilisable dans des multimètres numériques.

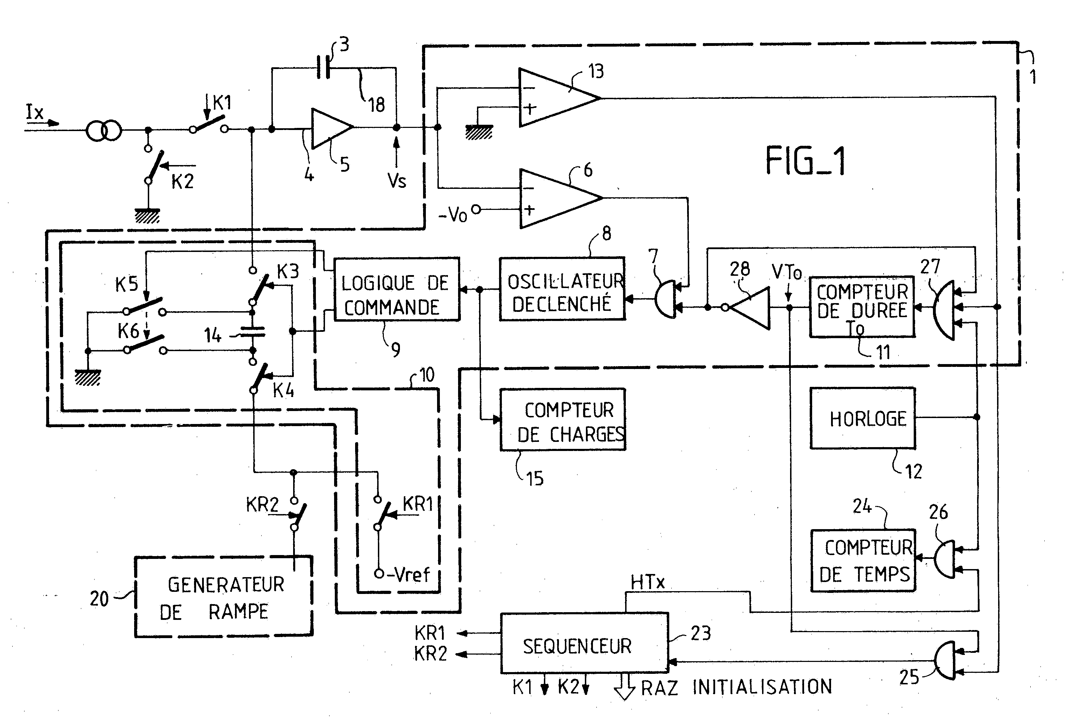

La figure 1 représente un convertisseur analogique numérique conforme à l'invention permettant de convertir un signal Ix en une valeur numérique. Dans le reste de la description, on considèrera Ix positif. Ce convertisseur comprend des moyens pour intégrer un signal Ix pendant une durée To. Ces moyens pour intégrer sont formés par un amplificateur opérationnel 5 monté en intégrateur par le rebouclage d'un condensateur 3 d'intégration. Ce condensateur 3 constitue les moyens d'accumulation desdits moyens d'intégration. Dans le reste du texte on nommera par intégrateur les moyens d'intégration. Ce convertisseur comprend par ailleurs des moyens 1 pour injecter dans le condensateur 3 des charges électriques quantifiées. Ces charges électriques quantifiées sont envoyées en un débit proportionnel à l'amplitude du signal Ix à quantifier de la manière suivante. Pendant une durée To après fermeture d'un interrupteur K1, relié entre le signal Ix et l'entrée des moyens d'intégration, le signal Ix est introduit à l'entrée 4 de l'intégrateur. Soumis à ce signal Ix l'intégrateur 3-5 commence à intégrer. La tension Vs, à sa sortie évolue. Quand cette tension atteint en amplitude une valeur -Vo un comparateur à seuil 6 bascule et entraîne, par le jeu d'une porte logique 7, d'un oscillateur déclenché 8, d'une logique de commande 9, et d'un générateur de charges quantifiées 10, l'injection de charges quantifiées dans le condensateur 3 de l'intégrateur.

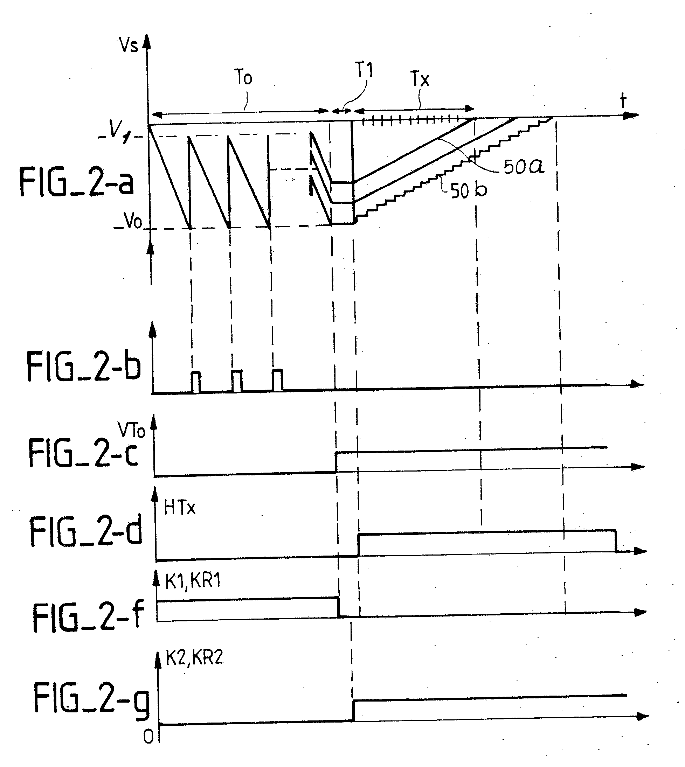

La figure 2a montre l'évolution de la tension Vs à la sortie de l'intégrateur 3-5 pendant la durée To. La durée To est décomptée par un compteur 11 de durée To relié à une horloge 12 d'une part, et à un comparateur de déclenchement 13 d'autre part. Le comparateur de déclenchement 13 déclenche le compteur dès qu'il détecte la première évolution du signal Vs à son premier passage par zéro. Le début de la durée To peut bien aussi être déclenché par un séquenceur 23 après une phase d'initialisation, autrement dit après remise à zéro de l'intégrateur et de sa tension d'offset. Comme on le verra plus loin, figure 2b, le signal de sortie du comparateur de déclenchement repasse par zéro une fois que le comptage fin est terminé : il marque utilement la fin du comptage des valeurs de poids faible dit aussi comptage fin. La figure 2c montre le nombre de coups produits par l'oscillateur déclenché 8 : chaque coup correspond à l'injection d'une charge. La figure 2d montre la durée pendant laquelle la sortie VTo du compteur 11 de durée To valide le fonctionnement de l'oscillateur déclenché 8. Dans le cas de la figure 1 le compteur 11 valide le fonctionnement de l'oscillateur uniquement lorsque sa sortie est au niveau bas.

Le fonctionnement du générateur 10 de charges (ou premier générateur de charges) est le suivant. Pendant toute la durée To, un interrupteur KR1 connecte une tension de référence -Vref à un condensateur 14 de quantification. A chaque impulsion de l'oscillateur déclenché, la logique de commande 9 provoque d'une part l'ouverture de deux interrupteurs K5 et K6 qui, lorsqu'ils sont fermés, court-circuitent le condensateur 14 à la masse, et ultérieurement d'autre part la fermeture de deux interrupteurs K3 et K4 qui ont pour effet de mettre en série le condensateur 14 entre l'entrée de l'intégrateur et la borne d'application de la tension -Vréf. Une charge quantifiée d'une valeur donnée égale à C14.Vréf est alors injectée dans le condensateur 3. La valeur C14 représente la capacité du condensateur 14. Cette charge injectée provoque l'évolution brutale constatée de la tension Vs à la sortie de l'intégrateur 3-5 qui varie de -Vo à -V1 = Vréf.C14/C3 - Vo, C3 représentant la capacité du condensateur 3.

Le convertisseur de l'invention comporte aussi un compteur 15 qui constitue des moyens de comptage gros pour compter le nombre de charges quantifiées ainsi injectées par le générateur de charge 10 dans le condensateur 3. A l'issue de la période To le signal à la sortie de l'amplificateur 5 peut avoir diverses valeurs de tension. Cette tension résiduelle à la sortie de l'amplificateur 5 correspond à l'accumulation de charges électriques dans le condensateur 3. La quantification de cette charge résiduelle constitue les valeurs de poids faible du signal quantifié correspondant au signal Ix.

L'élaboration de ces valeurs de poids faible est obtenue en comptant la durée de décharge à courant constant du condensateur 3. La prise en compte de la charge résiduelle nécessite l'ouverture de l'interrupteur K1 et la fermeture légèrement plus tard d'un interrupteur K2 relié à l'entrée du signal Ix, en amont de l'interrupteur K1, et à une masse. Une des particularités de l'invention réside dans la structure des moyens pour prendre en compte et décharger. Ceux-ci comportent naturellement un générateur de charge (ou deuxième générateur de charges). Celui-ci a la particularité, ici, d'utiliser le condensateur 14 de quantification. En définitive, autant on a utilisé le condensateur 14 pour injecter dans la première phase des charges quantifiées à l'entrée de l'intégrateur pour neutraliser les effets du signal Ix, autant on va continuer à injecter maintenant d'autres charges à courant constant pour annuler la tension aux bornes du condensateur 3. Pour obtenir une quantification de la charge résiduelle on mesure le temps de décharge Tx (Q = I. Tx) du condensateur 3. Dans un exemple, montré sur la figure 1, cette décharge à courant constant est obtenue par l'ouverture de l'interrupteur KR1 et par la fermeture d'un interrupteur KR2 qui soumettent le condensateur 14 à un générateur de rampe de tension 20.

La tension appliquée aux bornes du condensateur 14 varie alors linéairement avec le temps puisque la tension du générateur de rampe 20 évolue linéairement. En conséquence le courant de décharge appliqué au condensateur 3 est constant. Dans ces conditions la tension disponible à la sortie de l'amplificateur 5 évolue linéairement vers zéro (50 a, figure 2a)

Dans cette deuxième phase de quantification qui sert à élaborer les valeurs de poids faible, l'oscillateur déclenché 8 est arrêté et la logique de commande 9 est prévue pour que les interrupteurs K3 et K4 soient fermés tandis que les interrupteurs K5 et K6 sont ouverts. L'organisation de toute la quantification est effectuée sous le contrôle d'un séquenceur 23 qui reçoit le signal de fin de comptage gros du compteur 11 de durée To, et qui provoque à cet instant le basculement des interrupteurs K1 puis K2 (figures 2f et 2g), le basculement des interrupteurs KR1 puis KR2 pour brancher le générateur de rampe 20, et le démarrage d'un compteur de temps 24. Le compteur 24 est arrêté lorsque le comparateur de déclenchement 13 indique au séquenceur 23 par l'intermédiaire d'une porte 25 que le signal Vs est repassé par zéro. Le comptage du compteur 24 constitue l'ensemble des valeurs de poids faible. Pour des raisons de fonctionnement le compteur 24 reçoit, avec un ordre HTx (figure 2d) provenant du séquenceur 23, un signal d'horloge provenant de l'horloge 12 sur une porte ET 26. De même une porte 27 et un inverseur 28 organisent le fonctionnement du compteur 11 de durée To.

Le choix d'un condensateur 14, pour décharger la tension aux bornes du condensateur 3, évite d'avoir à créer une constante de temps de décharge de ce condensateur 3 au moyen d'une résistance dont on a indiqué qu'elle était soit coûteuse à fabriquer, soit impossible à intégrer sur un circuit intégré semiconducteur. Le séquenceur 23 provoque, à la fin de la durée To et avant le comptage fin, la stabilisation des charges stockées avant la décharge du condensateur 3. Cette durée T1 est utile pour assurer la séparation de la conduction des interrupteurs K1 et K2, et KR1 et KR2.

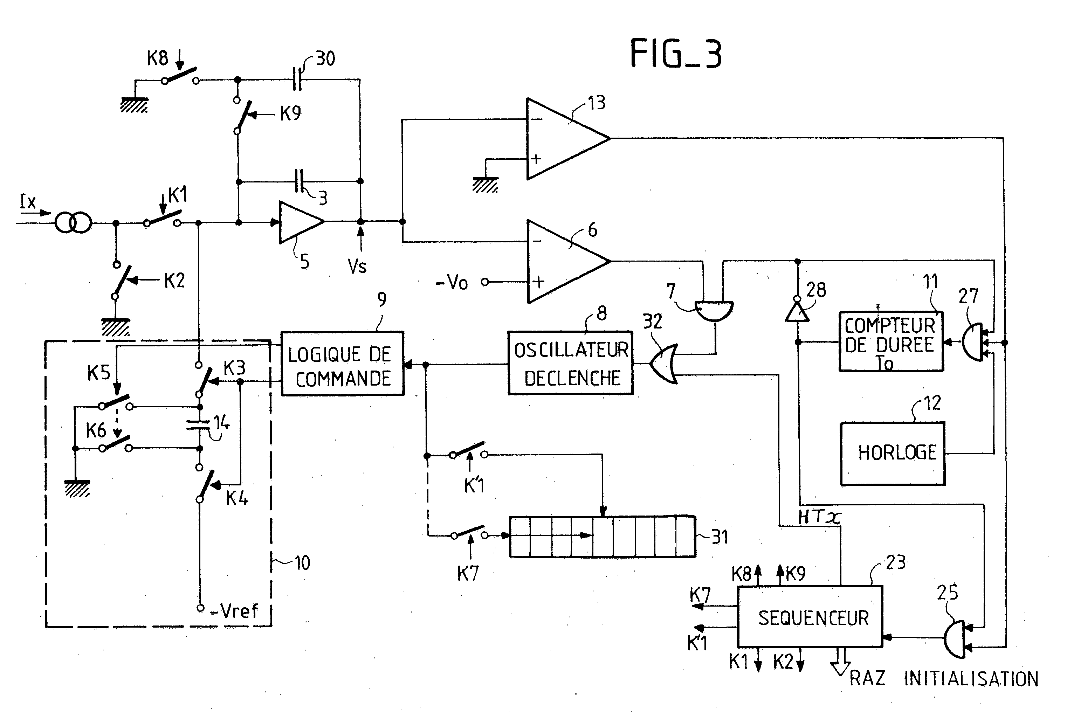

La figure 3 montre une variante du convertisseur de l'invention. Dans celle-ci on n'utilise pas de générateur de rampe qui pourrait éventuellement être difficile à implanter, par exemple sur un multimètre numérique. On préfère utiliser le générateur de charge 10 (ou premier générateur de charge) en entier comme générateur de décharge (ou deuxième générateur de charge). On utilise même comme tension de décharge la même tension de référence que celle qui a été utilisée pendant la première phase : pour l'élaboration des valeurs de poids fort. Cependant, étant donné que par définition la charge résiduelle est faible, si on n'y prenait garde on déchargerait ainsi en une seule fois cette charge résiduelle du condensateur 3 dans le condensateur 14. On n'obtiendrait pas les valeurs de poids faible demandées. Pour remédier à cet inconvénient, on installe, en parallèle avec le condensateur 3, un condensateur 30 qui lui est relié conditionnellement par un jeu d'interrupteurs K8 et K9 reliés respectivement à une masse et à l'entrée de l'intégrateur. Le condensateur 30 présente une capacité notablement plus forte que celle du condensateur 3. Dans un exemple, elle est mille fois plus forte. Elle est, par rapport à la capacité du condensateur 3, d'autant plus forte qu'on veut plus de précision, donc plus de valeurs de poids faible. Les condensateurs 3 et 30 constituent les moyens d'accumulation des moyens d'intégration du convertisseur.

Pendant la première phase d'élaboration des valeurs de poids fort, l'interrupteur K8 est fermé tandis que l'interrupteur K9 est ouvert. En conséquence la même tension de sortie Vs de l'amplificateur opérationnel 5 est appliquée au condensateur 3 d'une part et au condensateur 30 d'autre part. Ce condensateur, vu le gain de l'amplificateur opérationnel 5, se charge également et se décharge au cours de cette première phase comme le condensateur 3. A l'issue de la première phase, la charge résiduelle est représentée par les charges stockées, en faible nombre, dans le condensateur 3, mais en très grand nombre dans le condensateur 30. Avant le début de la deuxième phase, on ouvre l'interrupteur K8 tandis que l'on ferme l'interrupteur K9. Sans changer significativement la tension de sortie de l'amplificateur 5 on augmente ainsi considérablement le nombre des charges à décharger par le circuit de décharge 10. Dans ces conditions, on peut utiliser un même circuit 10 que précédemment pour décharger.

Alors que, dans l'exemple précédent, la logique 9 de commande avait été neutralisée par l'arrêt du déclenchement, par la porte 7, de l'oscillateur déclenché 8, il convient maintenant d'autoriser à nouveau le fonctionnement de cet oscillateur déclenché 8. Autrement dit elle est remise en service après le temps To est le temps T1 nécessaire pour effectuer les commutations de K1, K2, K1', K7 et stabiliser les charges. La figure 2a montre une rampe en escalier 50b dont les marches sont dues aux déclenchements successifs de l'oscillateur déclenché 8 pendant la deuxième phase du comptage. Cependant, autant dans l'exemple de la figure 1 les valeurs de poids fort ont pu dans un exemple être élaborés par le compteur de charges 15, autant il convient maintenant d'élaborer les valeurs de poids fort et de poids faible par un compteur de charges 31 branché en sortie de l'oscillateur déclenché. Une porte OU 32 branchée à la sortie de la porte ET 7 et recevant par ailleurs le signal HTx permet d'autoriser à nouveau le fonctionnement de l'oscillateur déclenché tandis que le séquenceur 23 est maintenant organisé pour provoquer l'ouverture et la fermeture des interrupteurs K8, K9 et K'1 et K7 qui respectivement mettent en service le condensateur 30 et qui commutent des entrées du compteur 31.

Lorsque le seuil Vo n'est pas très précisément connu, la tension Vs ne revient pas strictement à zéro après le retrait d'une décharge Q. Il en résulte qu'à la fin de la période To de comptage des charges Q (valeurs de poids fort), la charge résiduelle dans le condensateur 3 peut être supérieure à Q. Cela a pour conséquence que les valeurs de poids fort et les valeurs de poids faible ne peuvent en fait pas être juxtaposées. Elles doivent être additionnées. Dans la figure 3 la flèche contenue dans le compteur 31 indique symboliquement la propagation de la retenue qui doit être entreprise en comptant les valeurs de poids faible.

Ainsi, le compteur 15 et le compteur 24 de la figure 1 peuvent être remplacés par un compteur unique tel que le compteur 31 de la figure 3. Si le comptage est binaire il faut que les forts poids et les faibles poids soient dans un rapport binaire : une puissance n de 2. Ainsi dans un même compteur binaire on peut compter les valeurs de poids forts et les valeurs de poids faible à condition d'entrer au moyen des interrupteurs K'1 et K7, les valeurs de poids fort n étages plus loin que les valeurs de poids faible. A l'intersection entre les deux parties les mesures des valeurs de poids fort et de poids faible se chevauchent. Dans cette organisation le compteur contient bien la somme des deux mesures (fort et faible poids).

L'avantage des deux solutions présentées dans les figures 1 et 3 est constitué par le fait d'utiliser un même élément précis, le condensateur 14, pour définir les charges injectées, d'une part pendant la première phase, et pendant la durée de décharge continue ou impulsionnelle de la charge résiduelle d'autre part. Ce choix d'un même composant apporte en outre, indépendamment du mode nouveau de mesure, une homogénéité de l'élaboration des valeurs de poids fort et des valeurs de poids faible.

Dans une application utilisant plusieurs convertisseurs le compteur de To et le séquenceur 23 peuvent être communs à tous les convertisseurs. Le séquenceur déclenche alors le comptage de To pour tous les convertisseurs en même temps, après une phase d'initialisation permettant de décharger complètement l'intégrateur et d'étalonner les zéro des amplificateurs et les seuils des comparateurs.

L'oscillateur déclenché 8 peut être remplacé par un monostable fournissant une seule impulsion quand le seuil est franchi, et par un monostable qui provoque la décharge du condensateur 3 au cas où le courant d'entrée serait supérieur au courant de saturation.

La description donnée en référence aux figures a été faite pour un convertisseur analogique numérique de courant. Pour réaliser un convertisseur analogique numérique de tension, il suffit de transformer le signal de tension en signal de courant en ajoutant par exemple une résistance en série à l'entrée du signal à quantifier.

**Revendications**

1 - Convertisseur analogique numérique à grande dynamique du type comportant
- des moyens (3-5) pour intégrer un signal à quantifier (Ix) pendant une durée (To), ces moyens comportant des moyens (3) pour accumuler des charges provenant du signal à quantifier
- des moyens (1) pour injecter dans les moyens d'accumulation des charges électriques quantifiées (14, Vref) en un nombre proportionnel au dit signal à quantifier, les charges injectées étant de polarité inverse aux charges provenant du signal à quantifier,
- des moyens (15) de comptage dits gros pour compter le nombre de charges quantifiées injectées, et en déduire une quantification en valeurs de poids fort du signal,
- des moyens pour prendre en compte et décharger une charge électrique résiduelle accumulée (Vs) dans les moyens d'accumulation à l'issue de la durée donnée,
- des moyens (12, 13, 24) de comptage dits fins pour compter une durée proportionnelle à la décharge de la charge résiduelle accumulée, et en déduire une quantification en valeurs de poids faible du signal,
- les moyens pour injecter comportant un premier générateur de charge quantifiée muni d'un premier condensateur de quantification,

caractérisé en ce que

- les moyens pour prendre en compte et décharger comportent un deuxième générateur de charge (10) muni d'un deuxième condensateur (14) de quantification.

2 - Convertisseur selon la revendication 1 caractérisé en ce que le deuxième condensateur (14) de quantification est le même (14) que le premier condensateur de quantification.

3 - Convertisseur selon la revendication 2 caractérisé en ce que le deuxième générateur de charge comporte un générateur (20) de rampe déclenché après la durée donnée.

4 - Convertisseur selon la revendication 1 ou la revendication 2 caractérisé en ce que les moyens pour accumuler comportent un premier condensateur relié d'une part à l'entrée d'un amplificateur opérationnel de moyens d'intégration et d'autre part à la sortie dudit amplificateur, et un deuxième condensateur (30) de capacité supérieure à celle du premier condensateur relié d'une part soit (K8) à un potentiel constant soit (K9) à l'entrée de l'amplificateur et d'autre part à la sortie dudit amplificateur.

5 - Convertisseur selon l'une quelconque des revendications 1 à 4 caractérisé en ce que les moyens de comptage dits gros et les moyens de comptage dits fins comprennent un compteur (31) commun comportant une première et une deuxième entrée distincte pour recevoir les quantifications en valeurs de poids fort et faible.

FIG_1

EP 0 313 460 A1

FIG_2-a

FIG_2-b

FIG_2-c

FIG_2-d

FIG_2-f

FIG_2-g

FIG_3

COMPTEUR DE DUREE To — 11
HORLOGE — 12
27
28
SEQUENCEUR — 23
25
RAZ INITIALISATION
K8 — K9
K7 — K1 — K1 — K2
HTx
OSCILLATEUR DECLENCHE — 8
7
32
31
K'1
K7
13
6
LOGIQUE DE COMMANDE — 9
−Vo
30
K9
Vs
5 — 3
K8
K1
K2
K3 — 14 — K4
K5 — K6
−Vref — 10
Ix

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-1 416 241  (HEWLET PACKARD)<br>* Page 1, colonne 1, ligne 26 - page 2, colonne 2, ligne 27; figure * | 1 | H 03 M    1/60<br>H 03 M    1/52 |
| A | PATENT ABSTRACTS OF JAPAN, vol. 8, no. 44 (E-299)[1481], 25 février 1984, page 111 E 229; & JP-A-58 200 633 (HITACHI SEISAKUSHO K.K.) 22-11-1983 | 1 | |
| A | PATENT ABSTRACTS OF JAPAN, vol. 7, no. 178 (E-191)[1323], 6 août 1983, page 130 E 191; & JP-A-58 84 535 (HITACHI SEISAKUSHO K.K.) 20-05-1983 | 1 | |

DOMAINES TECHNIQUES
RECHERCHES (Int. Cl.4)

H 03 M    1/60
H 03 M    1/52

Le présent rapport a été établi pour toutes les revendications

| Lieu de la recherche | Date d'achèvement de la recherche | Examinateur |
|---|---|---|
| LA HAYE | 19-12-1988 | GUIVOL Y. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons
............................................................................
& : membre de la même famille, document correspondant

EPO FORM 1503 03.82 (P0402)